(19) Europäisches Patentamt
European Patent Office
Office européen des brevets

(11) Numéro de publication : **0 014 116**
**B1**

(12) # FASCICULE DE BREVET EUROPÉEN

(45) Date de publication du fascicule du brevet : **24.02.82**

(51) Int. Cl.³ : **H 01 L 33/00**, H 01 L 21/208

(21) Numéro de dépôt : **80400034.7**

(22) Date de dépôt : **11.01.80**

(54) **Composant semiconducteur à hétérojonction.**

(30) Priorité : **26.01.79 FR 7902098**

(43) Date de publication de la demande : **06.08.80 (Bulletin 80/16)**

(45) Mention de la délivrance du brevet : **24.02.82 Bulletin 82/08**

(84) Etats contractants désignés : **DE GB**

(56) Documents cités :
**DE - A - 2 028 572**
**FR - A - 2 045 776**
**FR - A - 2 162 373**
**APPLIED PHYSICS LETTERS, vol. 27, no 4, 15 août 1975, New York, US, W.R. HITCHENS et al. : « Low-threshold LPE $In_{1-x'}Ga_{x'}P_{1-z'}As_{z'}/In_{1-x}Ga_xP_{1-z}As_z/In_{1-x'}Ga_{x'}P_{1-z'}As_{z'}$ », yellow double-heterojunction laser diodes $j < 10^4 A/cm^2$, $\lambda \sim 5\,850$ Å, 77 °K) pages 245-247.**
**APPLIED PHYSICS LETTERS, vol. 29, no 3, 1 août 1976, New York, US, JJ. COLEMAN et al. : « Pulsed room-temperature operation of $In_{1-x}Ga_xP_{1-z}As_z$ double heterojunction lasers at high energy (6 470 Å, 1.916eV) », pages 167-169.**
**APPLIED PHYSICS LETTERS, vol. 33, no 1, 1 juillet 1978, New York, US, C.K. KIM et al. : « Improved GaAs MES FET with a thin in situ buffer grown by liquid phase epitaxy », pages 92-94.**

(73) Titulaire : **THOMSON-CSF**
**173, Boulevard Haussmann**
**F-75360 Paris Cedex 08 (FR)**

(72) Inventeur : **Pearsall, Thomas**
**"THOMSON-CSF" - SCPI 173, bld Haussmann**
**F-75360 Paris Cedex 08 (FR)**

(74) Mandataire : **Giraud, Pierre et al**
**"THOMSON-CSF" - SCPI 173, bld Haussmann**
**F-75360 Paris Cedex 08 (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Imprimerie Jouve, 18, rue St-Denis, 75001 Paris, France

EP 0 014 116 B1

Composant semiconducteur à hétérojonction

L'invention a pour objet un composant semiconducteur à hétérojonction. Par composant semiconducteur à hétérojonction on désignera dans ce qui suit un composant comportant un substrat, sur lequel ont été formées, le plus souvent par épitaxie, les couches de compositions différentes. De tels composants sont bien connus dans la technique, les substrats étant en général faits d'alliage GaAs (Arséniure de Gallium) ou d'InP (alliage de phosphore et d'indium), les couches actives, c'est-à-dire celles qui contribuent directement au fonctionnement du composant sont en général faites de mélanges ternaires ou quaternaires, comportant des éléments incorporés (dopants).

C'est le cas en particulier des diodes électroluminescentes, des diodes photodétectrices, des transistors à effet de champ de type MESFET (transistor à effet de champ et grille de type Schottky) qui comportent des zones actives qui sont le siège de l'émission lumineuse, de l'absorption de photons, et où se forme le canal de conduction dans le cas des MESFET.

Dans le cas des diodes électroluminescentes par exemple de type « laser » la zone active doit être encadrée de deux couches ayant une largeur de bande interdite plus élevée que celle de la zone active.

Or, pour obtenir une largeur de bande interdite plus élevée que celle de la zone active, il est nécessaire d'utiliser un matériau semiconducteur différent. En pratique, on fait souvent varier la composition de l'alliage constituant ce matériau pour le différencier de celui de la couche active. On peut notamment citer l'article de W.R. HITCHENS et al. publié dans « Applied Physics Letters », Vol. 27, n° 4, 15 août 1975, pages 245 à 247, et le fascicule de brevet DE-A 2 028 572 concernant l'utilisation de semiconducteurs du type GaInAsP.

Mais il apparaît alors un inconvénient résultant de l'impossibilité de concilier parfaitement la différence de composition des alliages avec l'égalité des dimensions de maille cristalline et des coefficients de dilatation linéaire. La recherche d'un compromis est encore rendue plus difficile par le fait que si l'égalité des mailles est réalisée à la température de fabrication du cristal, c'est-à-dire au cours de l'épitaxie en phase liquide, qui constitue le moyen le plus utilisé, à des températures allant de 500 °C à 1 000 °C, ladite égalité n'est plus vérifiée à la température ambiante ni même à la température de fonctionnement du composant.

Il se pose notamment un problème en cas d'élévation de température, puisque les coefficients de dilatation divergent lorsque la température varie. En cas d'élévation ou d'abaissement brusque de la température il peut se produire un « choc thermique » entraînant soit le bris du composant, soit des fêlures microscopiques qui sont d'autant plus gênantes pour le bon fonctionnement du composant opto-électronique qu'elles sont plus proches de la couche active.

L'invention tend à éliminer ces inconvénients en créant une couche tampon entre le substrat et la couche active, tout en réalisant le meilleur compromis possible entre les contraintes imposées par la nécessité de l'inégalité de largeur de bande interdite, l'égalité de maille cristalline au moment de l'épitaxie, et les dangers de fêlures atteignant la couche active par suite de la différence des coefficients de dilatation linéaire.

Afin de tendre à éliminer ces inconvénients, le composant semiconducteur selon l'invention comporte un substrat constitué par un premier matériau semiconducteur présentant un premier coefficient de dilatation, et, déposées par épitaxie sur le substrat, au moins une première et une deuxième couches en un deuxième matériau semiconducteur de type ternaire ou quaternaire ayant une maille cristalline de dimension voisine de la maille cristalline du matériau du substrat, et présentant un coefficient de dilatation variable avec la composition de ce deuxième matériau. Ce composant est caractérisé en ce que les compositions des première et deuxième couches sont choisies de telle sorte que le coefficient de dilatation de la première couche soit intermédiaire entre les coefficients de dilatation du substrat et de la deuxième couche.

L'invention sera mieux comprise au moyen de la description ci-après en se référant aux dessins annexés parmi lesquels :

La figure 2 est une vue en coupe longitudinale d'un exemple de réalisation de l'invention.

La figure 1 représente le coefficient de dilatation relatif α d'un alliage de formule.

$$Ga_xIn_{1-x}As_yP_{1-y}$$

en fonction de x, avec x variant de 0 à 0,47, le rapport $\frac{y}{x}$ étant constant et sensiblement égal à 2,2. En ordonnées est porté le coefficient α. On a :

$$\alpha = \frac{\Delta a}{a}$$

« a » étant la dimension d'une maille du cristal. On constate d'une part que la pente de la courbe est forte pour x compris entre 0 et 0,25 environ et que pour x compris entre 0,35 et 0,47, cette pente est faible.

On sait que l'on peut faire croître par épitaxie en phase liquide un mélange quaternaire du type $Ga_xIn_{1-x}As_yP_{1-y}$, sur un substrat de phosphure d'indium InP. Cette opération se fait à une température de l'ordre de 600 °C.

Il en résulte que si l'on a un bon « accord de mailles » à 600 °C, cet accord disparaîtra à la température ambiante, qui est en général la température d'utilisation du semiconducteur. On voit

en effet que pour l'InP, le coefficient de dilatation est de $4,5 \times 10^{-6}$, et que pour $x = 0,25$ celui du matériau quaternaire est supérieur à $5.10^{-6}$. Par contre ce dernier varie peu pour $0,30<x<0,47$. Il en résulte que des contraintes existent à la température ambiante entre une couche ayant un paramètre x voisin de 0,45 et un substrat de phosphure d'Indium, ce qui diminue la fiabilité du composant.

Un premier exemple de réalisation est représenté figure 2. La figure 2 représente en coupe transversale, suivant l'axe longitudinal de sa cavité résonnante une diode photoluminescente du type « laser ».

Elle comporte un substrat 1 en Phosphure d'Indium sur la face inférieure duquel est placé un contact ohmique 2. Ce substrat de type de conductivité $n^+$ avec un dopage de l'ordre de $10^{19}$ at/$cm^3$ a une épaisseur de 10 à 100 $\mu$m. Sur ce substrat est déposée une première couche 3, de formule $Ga_{x_3}In_{1-x_3}As_{y_3}P_{1-y_3}$ d'épaisseur de 1 à 10 $\mu$m. Au-dessus de cette couche a été déposée la couche active 4 d'épaisseur plus faible, faite également d'un alliage quaternaire de 0,1 à 1 $\mu$m également faite d'un alliage quaternaire du même type $Ga_{x_4}In_{1-x_4}As_{y_4}P_{1-y_4}$.

Enfin la couche 4 est surmontée d'une couche 5 identique à la couche 3 et d'un contact ohmique 6. Les couches 3 et 5 ont des types de conductivité opposés, (n et p) le type de conductivité de la zone active peut être n ou p.

Le choix des paramètres $x_3$ et $x_4$, $y_3$ et $y_4$ est effectué de la manière suivante. On doit réaliser à la fois deux conditions :

a) réaliser des compositions de matériaux semiconducteurs telles que la largeur de bande interdite de la couche intermédiaire 4 soit plus petite que la largeur de bande interdite des couches 3 et 5, qui l'encadrent, condition exigée par le fonctionnement en diode laser ;

b) se placer selon l'invention, sur la courbe de la figure 1 en deux points A et B d'abscisses $x_3$ et $x_4$ telles que le coefficient de dilatation relatif au point A soit compris entre le coefficient de dilatation de InP, c'est-à-dire l'ordonnée à l'origine de la courbe et le coefficient de dilatation du matériau de la couche 4, c'est-à-dire l'ordonnée de B.

Un premier compromis consiste à choisir :

— d'une part, pour les couches 3 et 5 :

$0,05 \leq x_3 \leq 0,15$ avec $2x_3 \leq y_3 \leq 2,4x_3$

soit environ $0,1 \leq y_3 \leq 0,6$

— d'autre part, pour la couche 4 :

$0,20 \leq x_4 \leq 0,35$ avec $2x_4 \leq y_4 \leq 2,4x_4$

soit environ $0,4 \leq y_4 \leq 0,8$

un compromis plus serré consiste à choisir :

$x_3 = 0,1$ avec $y_3 = 0,22$

$x_4 = 0,27$ avec $y_4 = 0,59$

Dans ce dernier cas on obtient une diode laser émettant sur une longueur d'onde voisine de 1,3 micron (infrarouge).

## Revendications

1. Composant semiconducteur à hétérojonction, comportant un substrat (1) constitué par une premier matériau semiconducteur présentant un premier coefficient de dilatation, et, déposé par épitaxie sur le substrat, au moins une première (3) et une deuxième (4) couches en un deuxième matériau semiconducteur de type ternaire ou quaternaire ayant une maille cristalline de dimension voisine de la maille cristalline du matériau du substrat, et présentant un coefficient de dilatation variable avec la composition de ce deuxième matériau, caractérisé en ce que les compositions des première (3) et deuxième couches (4) sont choisies de telle sorte que le coefficient de dilatation de la première couche (3) soit intermédiaire entre les coefficients de dilatation du substrat (1) et de la deuxième couche (4).

2. Composant semiconducteur suivant la revendication 1, caractérisé en ce que le substrat (1) est en phosphure d'indium, les couches semiconductrices (3,4,5) étant en un matériau de composition :

$$Ga_xIn_{1-x}As_yP_{1-y}$$

dans laquelle x est compris entre 0,1 et 0,47 et y entre 0 et 1.

3. Composant semiconducteur suivant la revendication 2, caractérisé en ce que, pour constituer une diode laser, il comporte une première couche (3) de composition :

$$Ga_{x_3}In_{1-x_3}As_{y_3}P_{1-y_3}$$

où $x_3$ est compris entre 0,05 et 0,15 et $y_3$ entre $2x_3$ et $2,4x_3$ ;

une deuxième couche (4) de composition :

$$Ga_{x_4}In_{1-x_4}As_{y_4}P_{1-y_4}$$

où $x_4$ est compris entre 0,20 et 0,35 et $y_4$ entre $2x_4$ et $2,4x_4$ et une troisième couche en matériau de même composition que la première (3).

4. Composant semiconducteur suivant la revendication 3, caractérisé en ce que l'on a :

$x_3 = 0,1$ ; $y_3 = 0,22$ et

$x_4 = 0,27$ ; $y_4 = 0,59$

## Claims

1. Hetero-junction semiconductor component, comprising a substrate (1) constituted by a first semiconductor material having a first dilatation coefficient, on which substrate are epitaxially deposited at least one first layer (3) and one second layer (4) made of a second semiconductor material of the ternary or quaternary type which has a crystalline mesh the dimensions of which are close to those of the crystalline mesh of the substrate, and which has a dilatation coefficient that varies with the composition of said second material, characterized in that the compositions of the first layer (3) and the second layer (4) are selected in such a manner that the dilatation coefficient of the first layer (3) lies

between the dilatation coefficient of the substrate (1) and that of the second layer (4).

2. Semiconductor component according to claim 1, characterized in that the substrate (1) is made of indium phosphide, while the semiconductor layers (3, 4, 5) are made of a material having to following composition :

$$Ga_xIn_{1-x}As_yP_{1-y}$$

wherein x is comprised between 0.1 and 0.47, and y is comprised between 0 and 1.

3. Semiconductor component according to claim 2, characterized in that, with a view to forming a laser diode, it comprises a first layer (3) having the following composition :

$$Ga_{x_3}In_{1-x_3}As_{y_3}P_{1-y_3}$$

wherein $x_3$ is comprised between 0.05 and 0.15, and $y_3$ is comprised between $2x_3$ and $2.4x_3$ ;

a second layer (4) having the following composition :

$$Ga_{x_4}In_{1-x_4}As_{y_4}P_{1-y_4}$$

wherein $x_4$ is comprised between 0.20 and 0.35, and $y_4$ is comprised between $2x_4$ and $2.4x_4$ ; and third layer (5) made of a material having the same composition as that of the first layer (3).

4. Semiconductor component according to claim 3, characterized in that :

$x_3 = 0.1$ ; $y_3 = 0.22$ and

$x_4 = 0.27$ ; $y_4 = 0.59$

**Ansprüche**

1. Halbleiterbauteil mit heterogenen Sperrschichten, der eine aus einem ersten, einen ersten Ausdehnungskoeffizienten besitzenden Halbleiter bestehende Trägerschicht (1), sowie wenigstens eine auf die Trägerschicht epitaxial aufgebrachte erste Schicht (3) und eine auf die Trägerschicht epitaxial aufgebrachte zweite Schicht (4) aufweist, wobei die erste Schicht und die zweite Schicht aus einem zweiten, ternären bzw. quaternären Halbleiter bestehen, dessen Kristallmaschen-Abmessungen denjenigen des die Trägerschicht bildenden Materials annähernd entsprechen und welches einen in Abhängigkeit von der Zusammensetzung dieses zweiten Materials veränderlichen Ausdehnungskoeffizienten besitzt, dadurch gekennzeichnet, dass die jeweilige Zusammensetzung der ersten Schicht (3) und der zweiten Schicht (4) derart gewählt ist, dass der Ausdehnungskoeffizient der ersten Schicht (3) zwischen dem Ausdehnungskoeffizienten der Trägerschicht (1) und demjenigen der zweiten Schicht (4) liegt.

2. Halbleiterbauteil nach Anspruch 1, dadurch gekennzeichnet, dass die Trägerschicht (1) aus Indiumphosphid besteht, während die Halbleiterschichten (3, 4, 5) aus einem Material folgender Zusammensetzung bestehen :

$$Ga_xIn_{1-x}As_yP_{1-y}$$

wobei x eine zwischen 0,1 und 0,47 liegende Grösse und y eine zwischen 0 und 1 liegende Grösse darstellt.

3. Halbleiterbauteil nach Anspruch 2, dadurch gekennzeichnet, dass er eine Laserdiode bildet und eine erste Schicht (3) folgender Zusammensetzung aufweist :

$$Ga_{x_3}In_{1-x_3}As_{y_3}P_{1-y_3}$$

wobei $x_3$ zwischen 0,05 und 0,15, und $y_3$ zwischen $2x_3$ und $2{,}4x_3$ liegt, sowie eine zweite Schicht (4) folgender Zusammensetzung :

$$Ga_{x_4}In_{1-x_4}As_{y_4}P_{1-y_4}$$

wobei $x_4$ zwischen 0,20 und 0,35, und $y_4$ zwischen $2x_4$ und $2{,}4y_4$ liegt, und ferner eine dritte Schicht (5) aus einem Material, das die gleiche Zusammensetzung besitzt wie die erste Schicht (3).

4. Halbleiterbauteil nach Anspruch 3, dadurch gekennzeichnet dass :

$x_3 = 0{,}1$ ; $y_3 = 0{,}22$ und

$x_4 = 0{,}27$ ; $y_4 = 0{,}59$.

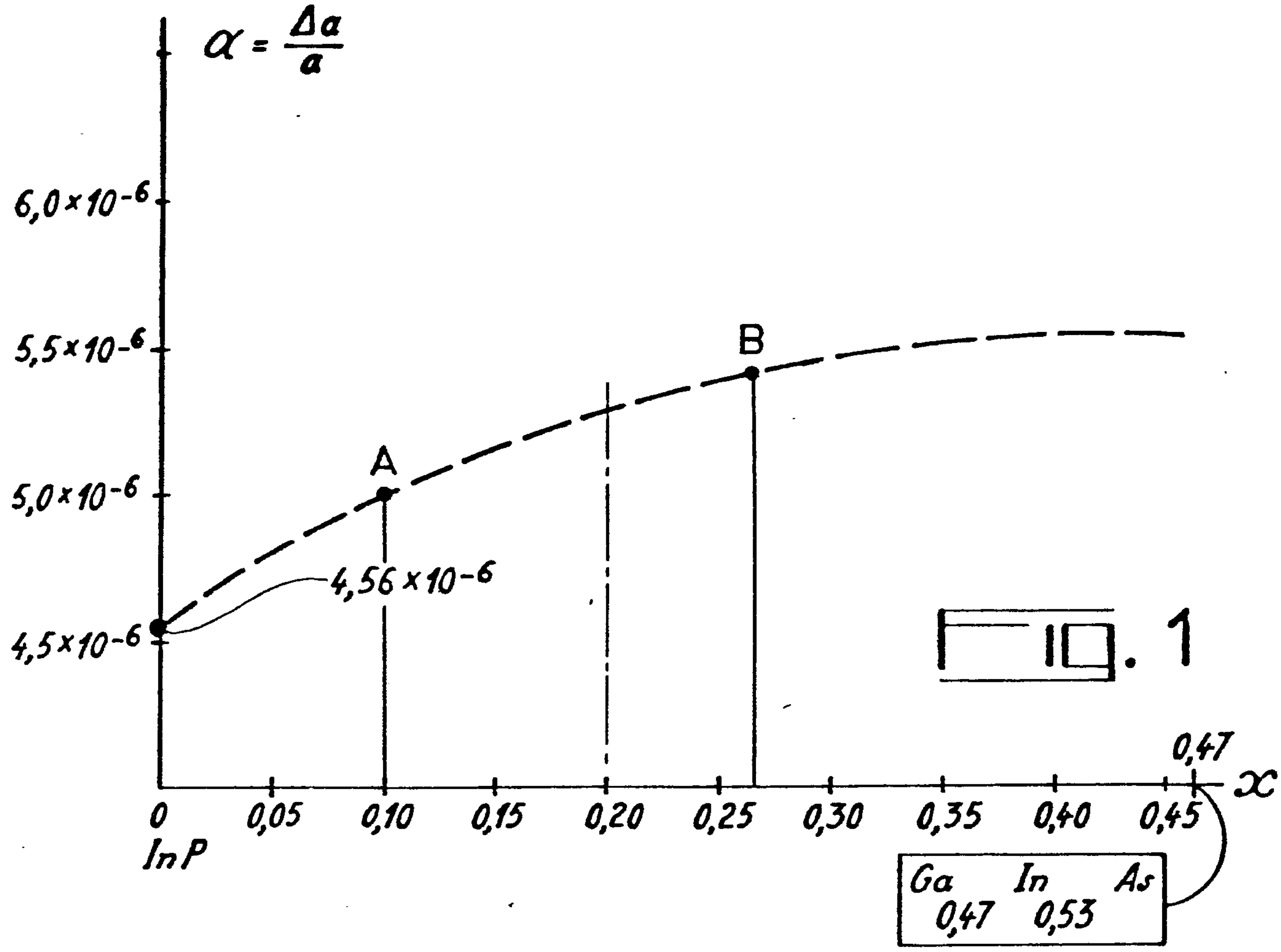

α = Δa/a
6,0×10⁻⁶
5,5×10⁻⁶
5,0×10⁻⁶
4,5×10⁻⁶
4,56×10⁻⁶
A
B
0
InP
0,05
0,10
0,15
0,20
0,25
0,30
0,35
0,40
0,45
0,47
x
Ga In As
0,47 0,53


Fig. 1

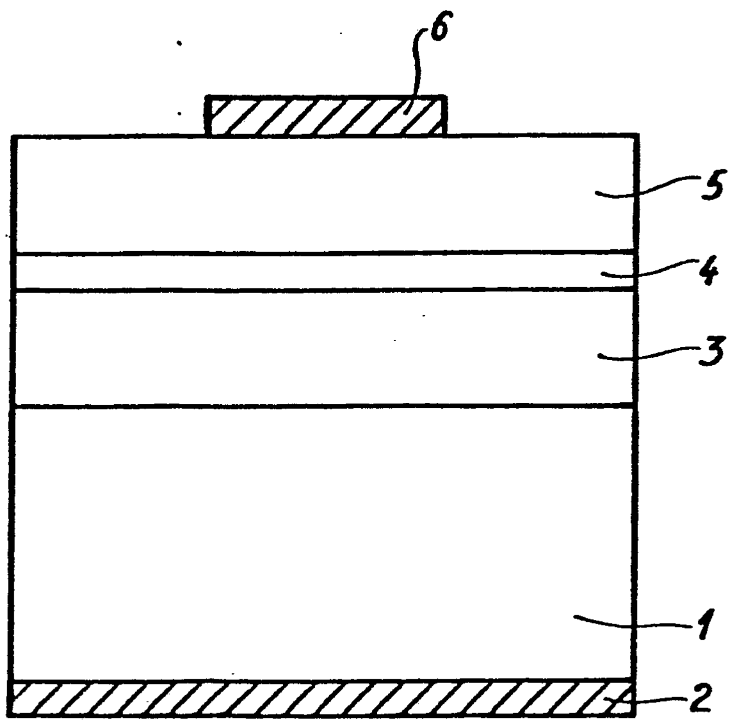

6
5
4
3
1
2


Fig. 2